# EUROPEAN PATENT APPLICATION

(11) **EP 2 960 509 A1**
(43) Date of publication of application: **30.12.2015**
(21) Application number: 15166840.7
(22) Date of filing: 07.05.2015
(51) Int. Cl.: F04B 39/12, H05K 7/14

(54) **CURRENT CONVERSION DEVICE FOR AN ELECTRICAL MACHINE, NOTABLY A DRIVE MOTOR OF A COMPRESSOR**

(30) Priority: 23.05.2014 FR 1454646
(71) Applicant: Valeo Japan Co., Ltd., Saitama 360-0193 (JP)
(72) Inventor: Guitari, Imed, 78990 ELANCOURT (FR); Lorimier, Marielle, 95490 VAUREAL (FR)
(74) Representative: Pellegrini, Marie Claude

(57) **Abstract**

The invention relates to a current conversion device for an electrical machine (3), notably a drive motor of a compressor (1), said device comprising a body (7), designed to be attached to said machine (3), said body (7) also being designed to be earthed.

## Description

The technical sector of the present invention is compressors, in particular electrical compressors, for example for circulating a coolant inside a vehicle air conditioning circuit.

An electrical compressor conventionally includes a compression mechanism, driven by an electric motor, in order to pressurize the coolant in the air conditioning circuit. To power the electric motor, the compressor also includes an inverter to convert the current available into a current suitable for the motor of the compressor. For example, the inverter is designed to convert a direct current into a three-phase alternating current.

Arrangements in which the inverter includes a housing attached to the housing of the motor are in particular known. In such an example, the link between the housing and the motor has a certain electrical resistance, which is even greater if an insulating gasket is placed between the housings of the inverter and the motor.

One difficulty to overcome in such an example is the transmission of electromagnetic disturbances, in particular to the windings of the motor as well as to the power network and to the low-voltage network, used respectively to power and to control operation of same. This is referred to as electromagnetic compatibility (EMC). Power network means a network in which electrical energy is converted into mechanical power. This may be high-voltage, for example an electrical voltage of approximately 48-250 V, compared to the voltage used for control, which is sometimes known as low-voltage.

Conventionally, these difficulties are overcome by connecting the electrical machine to the earth of the motor vehicle. However, although this solution works well for arrangements in which a single housing is used for the inverter and the motor, the applicant has noted that such a solution is inadequate in the arrangement mentioned above.

Indeed, in consideration of the high electrical resistance established between the housing of the inverter and the housing of the motor, the electromagnetic disturbances generated and/or transmitted by the inverter cannot be drained by the connection to earth, since this is linked to the housing of the motor. They are therefore transmitted by the electrical cables connected to the inverter, i.e. the cables of the power network and the low-voltage network, and/or the windings of the housing of the motor. This situation is all the more damaging since the inverter is the source of significant electromagnetic disturbances.

Numerous workarounds are known, such as using capacitors or printed circuit boards designed to filter out said disturbances. The situation could however be improved.

For this purpose, the invention proposes a current conversion device for an electrical machine, notably a drive motor of a compressor, said device comprising a body, designed to be attached to said machine, said body also being designed to be earthed.

By providing the body of said current conversion device with a dedicated connection to earth, any electrical resistance between said conversion device and the electrical machine is no longer an obstacle, thereby encouraging the dispersion of electromagnetic disturbances to earth rather than via the other electrical cables connected to said conversion device. This enables use of a more powerful conversion device without having to adopt solutions in which the conversion device and the electrical machine include a monobloc body, or to implement other workarounds that are costly and difficult to incorporate.

Advantageously, the body of the conversion device is earthed via an electrical cable of predetermined size and contained to be as short as possible. Consequently, the length of the cable is determined as a function of the distance separating the body of the conversion device and an earthing point formed either by the chassis of the vehicle or by the drive motor of this latter, or a torque-conversion or mechanical-power-transfer device, such as a dear device forming a gearbox of the vehicle.

Said current conversion device is, for example, an inverter. When used in a vehicle, earth may be the chassis of the vehicle.

According to other features of the invention, which may be used individually or in combination:
- said conversion device includes an electrical connector designed to be earthed,
- said body includes a first hole for receiving attachment means of said electrical connector,
- said first hole opens onto an outside surface of the body, referred to as the connection surface, said connection surface being flat,
- said connector has a plug designed to bear flat against said connection surface,
- said plug is perforated to enable said attachment means to pass through,
- said first hole is threaded,
- said body has a second hole for another electrical connector,
- said body has a third hole for another electrical connector,
- said first hole is positioned near to the second hole,
- said first hole is located on the same face of the body as the second hole,
- said body is cylindrical and the first hole is located in the same angular sector as the second hole, the angle of said angular sector being at least 120°,
- said first hole is oriented differently from the second hole,
- the orientations of the first and second holes are all different,
- said body is monobloc, notably formed by casting,
- said device includes current conversion means seated inside said body,
- said body is designed to enable cooling of said conversion means,
- said body includes holes for attachment to the electrical machine,
- said body includes holes for centring on the electrical machine.

The invention also relates to an assembly of a current conversion device as described above and an electrical machine, said current conversion device being mounted on said machine. An insulating gasket forming a seal is advantageously positioned between the body of said device and said machine.

Said machine may be designed to be attached to a chassis and said conversion device is cantilevered on said machine.

The invention also relates to a compression device including an assembly as described above and a compressor driven by said assembly.

The invention can be better understood from the description below, given purely by way of example and with reference to the attached drawings, in which:
- Figure 1 is a schematic perspective view of a compression device according to the invention provided with a connection to earth,
- Figure 2 is a perspective view of the body of a conversion device according to the invention.

The invention relates to a compression device. This latter may be used for compressing different types of fluid and may be mounted on any type of device, mobile or static. It is however more specifically intended for circulating a coolant inside an air conditioning circuit of a motor vehicle, being attached directly or indirectly to the chassis of same.

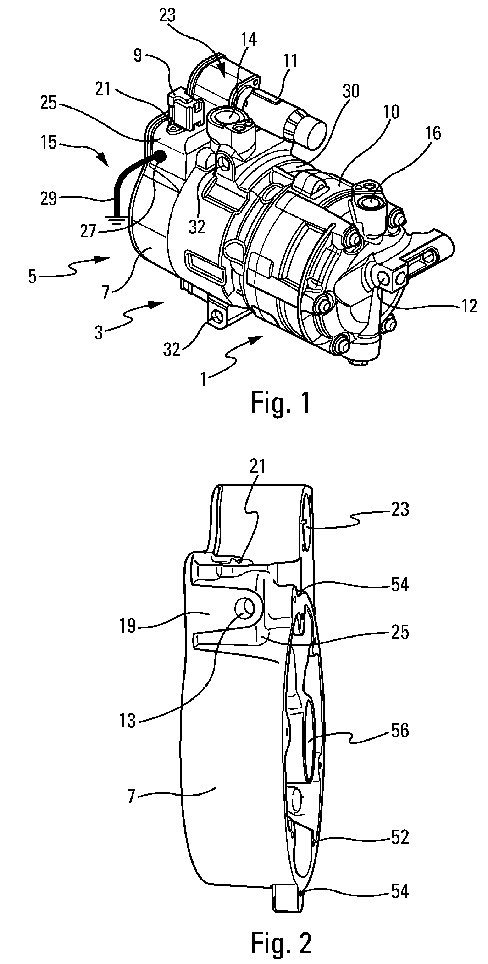

With reference to Figure 1, the electrical compression device according to the invention comprises a compressor 1, an electrical machine 3 for driving the compressor 3 and a current conversion device 5 mounted on said machine. Said conversion device 5 is designed to enable said electrical machine to be powered and controlled.

The compressor 1 is advantageously a scroll, rotary-vane or reciprocating mechanism, these examples being given for illustrative purposes without limiting the scope of the invention. Said electrical machine 3 is, for example, a three-phase electrical motor. Said conversion device 5 is, for example, an inverter, i.e. a device used to convert a direct current, for example supplied by a battery, into an alternating current, notably a three-phase alternating current.

In this case, the compressor 1 has a housing 10 containing the compression members. The electrical machine 3 has a housing 30 containing a stator and a rotor of said electrical machine. The housings are notably hollow cylinders. They extend longitudinally along a longitudinal axis common to a shaft of said compressor and to the rotor of said electrical machine. The housing 10 of the compressor and/or the housing 30 of the electrical machine are, for example, made of aluminium or aluminium alloy.

Said electrical machine 3 is advantageously designed to be attached to a supporting element, notably the chassis, the drive motor or the gearbox of the vehicle. The housing 30 of said electrical machine 3 therefore has one or more attachment holes 32, in this case two diametrically opposed attachment holes. Said attachment holes 32 of the electrical machine 3 are oriented, for example, tangentially to the housing 30 of same.

Said attachment holes 32 of the electrical machine form two first attachment points of the compression device to the supporting element of same. In this case, said compression device has a third attachment point 12 to the chassis located on the housing 10 of the compressor 1. Said third attachment point 12 is located, for example, at a longitudinal extremity of said compressor. It may also be an attachment hole, for example oriented in the same direction as the attachment holes 32 of the electrical machine 3.

Said compression device is advantageously designed such that the coolant flows through said electric machine 3 and comes into contact with said conversion device 5 in order to cool same. To achieve this, the compression device in this case has an inlet orifice 14 for the coolant, that is for example oriented radially and that is preferably located close to said conversion device 5. This ensures circulation of the fluid that comes into contact with said conversion device 5, facilitating the cooling thereof.

An internal passage for the fluid is provided between said electrical machine 3 and the compressor 1. Another orifice 16 used to output the fluid from the compression device is located on said compressor 1. By way of example, this orifice is oriented radially in relation to the compressor 1.

Said conversion device 5 has a body 7 designed to be mounted on the electrical machine 3. In other words, said body 7 and said housing 30 of the electrical machine 3 are two separate parts connected to one another. In consideration of the fluid circulating inside the electrical machine 3, said compression device advantageously has an insulating gasket, not shown, between the body 7 of said device and said electrical machine 3, notably the housing 30 of said electrical machine.

Said conversion device 5 is in this case cantilevered on said electrical machine 3. It is for example cylindrical and in particular coaxial with the housings 10, 30 of the compressor 1 and/or of the electrical machine 3.

Said conversion device notably includes current conversion means, not shown, contained in said body 7. Said conversion means may for example include transistor bridges mounted on printed circuit boards. In this case, said device also includes low-voltage electrical connectors 9 and/or power connectors 11 designed to link said conversion means respectively to a low-voltage network and/or a power network of the vehicle to power and control said electrical machine 3.

Said body 7 is advantageously monobloc, notably formed by casting. It may be designed to enable cooling of said conversion means.

According to the invention, said body 7 is also designed to be connected to earth, this latter being for example the chassis of the vehicle. This prevents the electromagnetic disturbances generated by and/or transmitted to the conversion means from being subsequently transmitted to the low-voltage network or the power network of the vehicle and/or to the electrical machine 3.

As shown in Figure 2, said body 7 in this case has a first hole 13 designed to receive the attachment means, not shown, of an electrical connector 15, shown schematically in Figure 1, which is intended to be earthed. Said first hole 13 is for example threaded.

Said first hole 13 opens onto an outside surface 19 of the body 7, referred to as the connection surface. Said connection surface 19 is advantageously flat to facilitate a good electrical contact with the connector 15.

Said body may have a second hole 21 and a third hole 23, which are respectively designed to cooperate with the electrical connector 9 of the low-voltage network and the electrical connector 11 of the power network of the vehicle.

Said first hole 13 is located in this case close to the second hole 21 and the third hole 23. All of these holes 13, 21, 23 are therefore located, for example, beside a radial projection 25 of the body 7. More generally, the first hole 13 may be located in the same angular sector as the second hole 21 and the third hole 23, the angle of said angular sector being at least 120°.

The orientation of said first hole 13 is, for example, different to the orientation of the second and/or third holes 21, 23. In this case, the orientations of the first, second and third holes are all different, notably orthogonal to one another.

For assembly on said electrical machine 3, said body 7 includes, for example, attachment holes 52, in this case six, regularly distributed about the periphery of same. It may also include holes 54 for centring on said electrical machine 3, in this case two, that are substantially diametrically opposed. Said body 7 also includes a central hole 56 located in the shaft of the rotor of the electrical machine 3.

Figure 1 shows that said connector 15 includes a plug 27, also shown schematically. Said plug 27 is advantageously designed to bear flat against said connection surface 19. Said plug is, for example, perforated to enable said connection means to pass through. Said connector 15 also includes, for example, a cable 29 that is firstly connected to said plug 27 and secondly designed to be earthed.

## Claims

1. Current conversion device (5) for an electrical machine (3), notably a drive motor of a compressor (1), said device (5) comprising a body (7), designed to be attached to said machine (3), said body (7) also being designed to be earthed.

2. Device according to Claim 1, **characterized in that** said body (7) has a first hole (13) designed to receive attachment means of an electrical connector (15) intended to be earthed.

3. Device according to Claim 2, **characterized in that** said first hole (13) opens onto an outside surface (19) of the body (7), referred to as the connection surface, said connection surface (19) being flat.

4. Device according to any one of Claims 2 or 3, **characterized in that** said body (7) has a second hole (21) for one or more other electrical connectors (9, 11).

5. Device according to Claim 4, **characterized in that** said first hole (13) is positioned near to the second hole (21).

6. Device according to any one of Claims 4 or 5, **characterized in that** - said first hole (13) is located on the same face of the body (7) as the second hole (21).

7. Device according to any one of Claims 4 to 6, **characterized in that** said body (7) is cylindrical and the first hole (13) is located in the same angular sector as the second hole (21), the angle of said angular sector being at least 120°.

8. Device according to any one of Claims 4 to 7, **characterized in that** said first hole (13) is oriented differently from the second hole (21).

9. Assembly of a current conversion device according to any one of the preceding claims and an electrical machine (3), said current conversion device being mounted on said machine (3).

10. Assembly according to Claim 9 including an insulating gasket forming a seal between the body (7) of said device and said machine (3).

11. Assembly according to anyone of the preceding claims, **characterised in that** said machine (3) is designed to be attached to a chassis and said conversion device is cantilevered on said machine (3).

12. Compression device including an assembly according to any one of the preceding claims and a compressor (1) driven by said assembly.
